# EUROPEAN PATENT SPECIFICATION

(11) **EP 1 652 573 B1**
(45) Date of publication and mention of the grant of the patent: **04.08.2010**
(21) Application number: 05023437.6
(22) Date of filing: 26.10.2005
(51) Int. Cl.: B01D 67/00, B01D 69/10, B01D 69/12, B01J 35/06, C01B 31/02, C01B 33/02

(54) **Method and device for manufacturing nanofilter media**
Herstellungsverfahren und Vorrichtung zur Herstellung eines Nanofiltermediums
Méthode de fabrication et appareil pour la fabrication d'un milieu de nanofiltration

(30) Priority: 02.11.2004 KR 2004088396
(43) Date of publication of application: 03.05.2006
(73) Proprietor: Korea Institute of Energy Research, Daejon 305-3433 (KR)
(72) Inventor: Park, Seok-Joo, Seo-gu, 302-781 Daejeon (KR); Lee, Si-Hyun, Yuseong-gu, 305-729 Daejeon (KR); Jeong, Soon-Kwan, Seo-gu, 302-739 Daejeon (KR); Park, Hyun-Seol, Yuseong-gu, 305-758 Daejeon (KR); Choi, Ho-Kyung, Daedeok-gu, 306-773 Daejeon (KR); Rhim, Young-Joon, Yuseong-gu, 305-762 Daejeon (KR)
(74) Representative: Schaeberle, Steffen

(56) References cited:
- WO-A-03/056078
- GB-A- 2 399 092
- US-A1- 2003 111 334
- US-A1- 2003 116 503
- US-A1- 2004 149 209
- HOLT J K ET AL: "Carbon nanotube-based membranes: a platform for studying nanofluidics" NANOTECHNOLOGY, 2004. 4TH IEEE CONFERENCE ON MUNICH, GERMANY 16-19 AUG. 2004, PISCATAWAY, NJ, USA,IEEE, 16 August 2004 (2004-08-16), pages 110-112, XP010767196 ISBN: 0-7803-8536-5

## Description

### BACKGROUND OF THE INVENTION

### 1. Field of the Invention

The present invention relates to a method of manufacturing nanofilter media, which are porous media composed of nanotubes or nanofibers formed on conventional microfilter media serving as a substrate by directly synthesizing and growing the nanotubes or nanofibers on the substrate, and to a device for manufacturing the nanofilter media.

### 2. Description of the Related Art

In general, nanofilter media obtained by attaching nanofiber to conventional microfilter media are known to improve the filtration efficiency without a large change in the permeability of the filter.

That is, the use of the nanofiber to manufacture the filter media results in novel filter media which are advantageous because they cause lower pressure drop while maintaining filtration efficiency equal to that of the conventional microfilter.

Further, filters made of the nanofibers are known to exhibit excellent ability to filter ultrafine contaminant particles, that is, nanoparticles. 'In the case where the filter is formed by applying the nanofiber on the surface of the microfilter media, the fine contaminant particles are collected on the surface of the filter media, and do not infiltrate deep into the region of the microfilter serving as a substrate, resulting in improved cleaning performance and restorability.

As a result, the lifetime of the filter is lengthened.

Recently, nanofilter media coated with the nanofiber have been manufactured by spinning the nanofibers on the fibrous microfilter serving as a substrate using an electrospinning technique.

However, since the electrospinning technique is a top-down manner in which the nanofibers are spun from the polymer solution by applying an electrical field between the capillary end and the substrate, the diameter of the nanofiber cannot be decreased below a lower limit.

US 2003/116503 A1 comprises a carbon nanotube manufacturing method, wherein a support is pretreated with a templated surfactant composition to assists with the formation of a nanotube layer.

Holt J K et al.: "Carbon nanotube-based membranes: a platform for studying nanofluidics" NANOTECHNOLOGY, 2004. 4th IEEE Conference on Munich, Germany 16-19 Aug. 2004, PISCATAWAY, NJ, USA, IEEE, 16 August 2004 (2004-06-16), pages 110-112, reports on carbon nanotube-based membranes on a Si support, wherein the catalyst used for nanotube growth is iron, deposited by electron beam evaporation wherein the nanotubes are actually grown in an atmospheric pressure CVD system.

US 2004/149209 A1 discloses a process and apparatus for the production of carbon nanotubes, the process comprising locating a substrate capable of supporting carbon nanotube growth in a localized heating zone within a reaction chamber and passing a gaseous carbonaceous material into the reaction chamber whereby the gaseous material undergoes pyrolysis under the influence of the heat to form carbon nanotubes on the substrate.

WO 03/056078 A refers to a hot wire production of single-wall carbon nanotubes wherein an apparatus comprises a process chamber and a hot wire positioned within the process chamber, the process chamber also containing a metal catalyst material which catalyzes the formation of the carbon nanotubes.

GB-A-2 399 092 discloses a method of producing nanotubes and/or nanofibers by the catalytic decomposition of a gas feedstock on a catalyst wherein the catalyst is impregnated and dispersed within a porous matrix.

### SUMMARY OF THE INVENTION

Accordingly, the present invention has been made keeping in mind the above problems occurring in the related art, and an object of the present invention is to provide a method of manufacturing nanofilter media, which are composed of nanotubes or nanofibers having a diameter unable to realize using a conventional process of manufacturing nanofibers, by directly synthesizing and growing the nanotubes or nanofibers on microfilter media serving as a substrate in a bottom-up manner.

Another object of the present invention is to provide a device for manufacturing the nanofilter media composed of the nanotubes or nanofibers.

According to the invention, the object is solved by the features of the independent claims. The sub-claims contain further preferred developments of the invention.

### BRIEF DESCRIPTION OF THE DRAWINGS

The above and other objects, features and advantages of the present invention will be more clearly understood from the following detailed description taken in conjunction with the accompanying drawings, in which:
FIG. 1 is a flowchart schematically showing the process of manufacturing nanofilter media, according to the present invention;
FIG. 2 is a view showing the process of heating catalyst nanoparticles attached to a fibrous or fabric microfilter, according to the present invention;
FIG. 3 is a view showing the process of heating the catalyst nanoparticles attached to a membrane microfilter, according to the present invention;
FIG. 4 is a view showing the synthesis and growth of the nanotubes or nanofibers on the fibrous or fabric microfilter, according to the present invention;
FIG. 5 is a view showing the synthesis and growth of the nanotubes or nanofibers on the membrane microfilter, according to the present invention; and
FIG. 6 is a view schematically showing the device for manufacturing the nanofilter media by synthesizing and growing the nanotubes or nanofibers, according to the present invention.

### DESCRIPTION OF THE PREFERRED EMBODIMENTS

In the present invention, a method of manufacturing nanofilter media is provided, which includes loading catalyst nanoparticles into a reactor equipped with microfilter media serving as a substrate to attach the catalyst nanoparticles to the microfilter media, feeding a source gas and a reactive gas onto the catalyst nanoparticles, heating the entire reactor or selectively heating the microfilter media provided in the reactor or the catalyst nanoparticles attached to the microfilter media provided in the reactor to synthesize and grow nanotubes or nanofibers from the heated catalyst nanoparticles, to prepare nanofilter media composed of the synthesized and grown nanotubes or nanofibers.

The catalyst particles include cobalt, nickel, iron, or alloys thereof.

The microfilter serving as a substrate includes a fibrous filter, a fabric filter, or a membrane filter.

The material for the microfilter media may be all of materials including a polymer, silicon oxide (SiO₂), alumina (Al₂O₃), ceramics, or metal oxides.

The catalyst nanoparticles are prepared according to inert gas condensation (IGC) processes such as resistance heating, plasma heating, induction heating or laser heating, chemical vapor condensation (CVC) processes using a resistance coil reactor, a flame reactor, a laser reactor or a plasma reactor, or liquid processes such as direct precipitation, coprecipitation, freeze drying or spray pyrolysis.

The catalyst nanoparticles may include a transition metal, sulfides, carbides, oxides or salts of the transition metal, or an organic compound containing the transition metal.

The catalyst nanoparticles formed of the transition metal may be prepared from the precursor of the above transition metal supported on the microfilter media serving as a substrate and converted into the transition metal through reduction, sintering, sulfurization or carbonization.

That is, the method of the present invention is characterized in that the catalyst nanoparticles are supported on the microfilter media serving as a substrate using painting, dipping, spraying or deposition.

The catalyst nanoparticles formed of the metal sulfide may include metal sulfide obtained by sulfurizing the catalyst nanoparticles of the transition metal with hydrogen sulfide (H₂S) or thiophene.

In addition, the catalyst nanoparticles formed of the metal sulfide may include nanoparticles formed of a solid particulate mixture comprising the transition metal and sulfur.

In addition, the catalyst nanoparticles formed of the metal sulfide may include nanoparticles in the form of droplets comprising an ionic solution of the transition metal and sulfur.

The catalyst nanoparticles formed of the organic compound may include nanoparticles in the form of droplets comprising the catalyst precursor in the form of nanodroplets.

The source gas may include a hydrocarbon gas or a silane gas, depending on the material used to manufacture nanotubes or nanofibers.

The reactive gas may include an inert gas, hydrogen gas, oxygen gas, or mixtures thereof, and may further include a cocatalyst such as hydrogen sulfide (H₂S) or thiophene, if required.

The inert gas may include helium (He) gas or argon (Ar) gas to transport the catalyst nanoparticles or dilute the reactive gas.

The catalyst nanoparticles may be heated using a resistance heater formed of resistance coils.

In addition, the catalyst nanoparticles may be heated using microwave radiation.

In addition, the catalyst nanoparticles may be heated using electromagnetic induction.

In addition, the catalyst nanoparticles may be heated using laser heating.

In addition, the catalyst nanoparticles may be heated using radio frequency (RF) heating.

The material for nanotubes or nanofibers may include carbon, silicon, or silicon oxides.

The nanofilter media may include filter media formed by synthesizing and growing the nanotubes or nanofibers on a conventional microfilter serving as a substrate in a bottom-up manner.

In addition, the nanofilter media may include filter media functioning to simultaneously collect dust and adsorb gas.

Further, the nanofilter media may include a catalyst filter, an antibiotic filter, or a deodorization filter, able to remove volatile organic compounds (VOCs), sterilize air and perform deodorization if additional metal nanoparticles are deposited on the nanotubes or nanofibers.

In addition, the nanofilter media may include high strength filter media having high mechanical strength, heat resistant filter media able to endure high temperatures, or chemical proof filter media which are resistant to predetermined chemicals.

The catalyst precursor is selected from among ferrocene, iron-pentacarbonyl, dicobalt-octacarbonyl, and nickel-carbonyl.

Further, the present invention provides a device for manufacturing nanofilter media, including a catalyst nanoparticle forming and feeding unit to form and feed the catalyst nanoparticles, a reactor equipped with microfilter media serving as a substrate to which the catalyst nanoparticles are attached, a reactive gas feeding unit to feed a source gas and a reactive gas into the reactor, and a heating unit to heat the catalyst nanoparticles provided into the reactor.

The catalyst nanoparticle forming and feeding unit includes a catalyst nanoparticle forming part, and further includes a nanoparticle classification part or a concentration controlling part to control the concentration of the nanoparticles, if required. Also, a vaporous catalyst precursor feeding part is further included to feed the precursor of the catalyst nanoparticles in vapor phase into the reactor.

In addition, the reactor includes a conveyor line through which the microfilter media are continuously transported.

The heating unit includes a power part to apply current to the resistance heater formed of resistance coils mounted around the reactor.

The heating unit includes a microwave generator to generate microwaves and a microwave guide connected to the above reactor to guide the microwaves.

The heating unit includes a high frequency coil mounted around the reactor and a power part to apply high frequency current to the high frequency coil.

The heating unit includes an RF generator mounted around the reactor.

The heating unit includes a laser generator mounted around the reactor and a lens assembly to concentrate laser light beams generated by the laser generator.

In the present invention, the nanotubes or nanofibers are synthesized and grown on conventional microfilter media, thereby manufacturing nanofilter media having higher filtration efficiency, in particular, better ability to filter nanoparticles, which are ultrafine particles, compared to a conventional microfilter.

In the present invention, microfilter media having low pressure drop and low filtration efficiency are used as a substrate, and thus, the nanotubes or nanofibers are appropriately synthesized and grown on the substrate, to manufacture filter media having lower pressure drop and the filtration efficiency superior to conventional filter media, that is, higher filter quality (FQ).

Further, the nanotubes or nanofibers, in particular, carbon nanotubes or carbon nanofibers formed of carbon, are synthesized and grown to manufacture the nanofilter media, which then are formed into chemical filters able to simultaneously adsorb and remove contaminant gas and filter particulate matter.

In addition, the metal nanoparticles are further deposited on the synthesized nanotubes or nanofibers, thereby manufacturing filter media of a catalyst filter, an antibiotic filter, or a deodorization filter able to remove VOCs, sterilize air, or perform deodorization.

Hereinafter, the present invention is fully described in an illustrative manner, with reference to the appended drawings. However, many modifications of the present invention are possible in light of the above teachings, and it should be understood that they are intended to be in the nature of description rather than of limitation. The present invention is provided to more completely illustrate it to those skilled in the art. Therefore, reference is now made to the drawings, in which the constituent components are exaggeratedly shown for clearer illustration and the same reference numerals are used throughout the different drawings to designate the same or similar components.

Below, the present invention is more specifically described through the appended drawings and the following description citing the drawings.

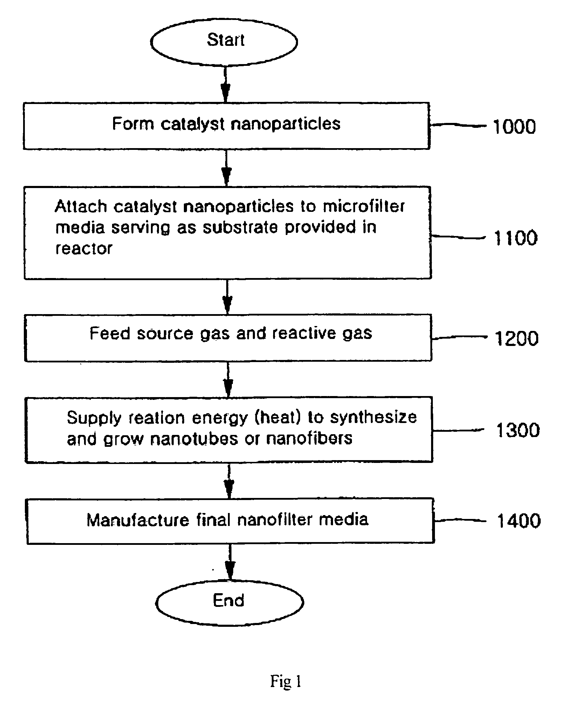

FIG. 1 is a flowchart illustrating the process of manufacturing the nanofilter media including nanotubes or nanofibers synthesized and grown on microfilter media serving as a substrate, according to the present invention.

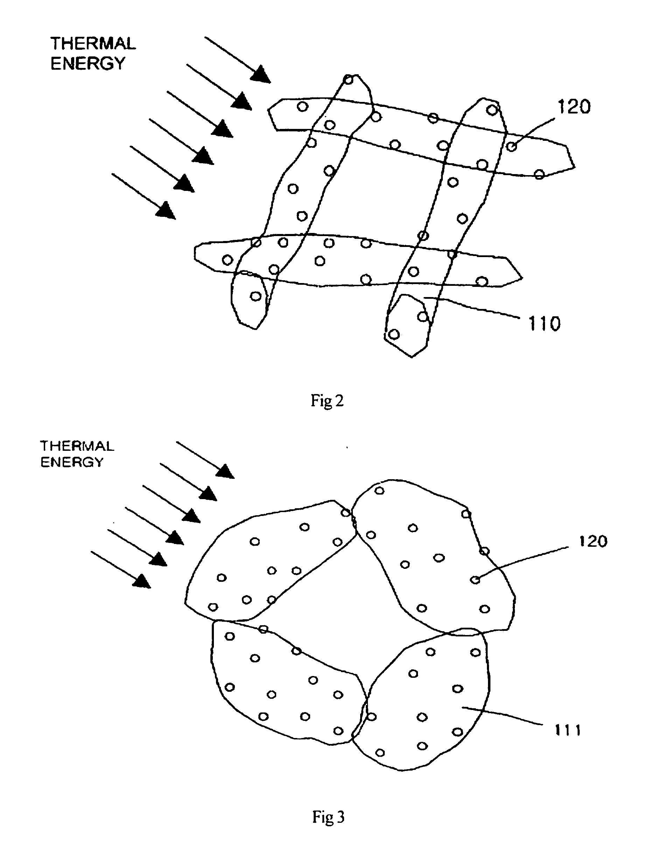

FIGS. 2 and 3 are views schematically illustrating the heating of the catalyst nanoparticles attached to the surface of the fibrous or fabric microfilter media and the surface of the membrane microfilter media while maintaining appropriate dispersion rates, according to the present invention.

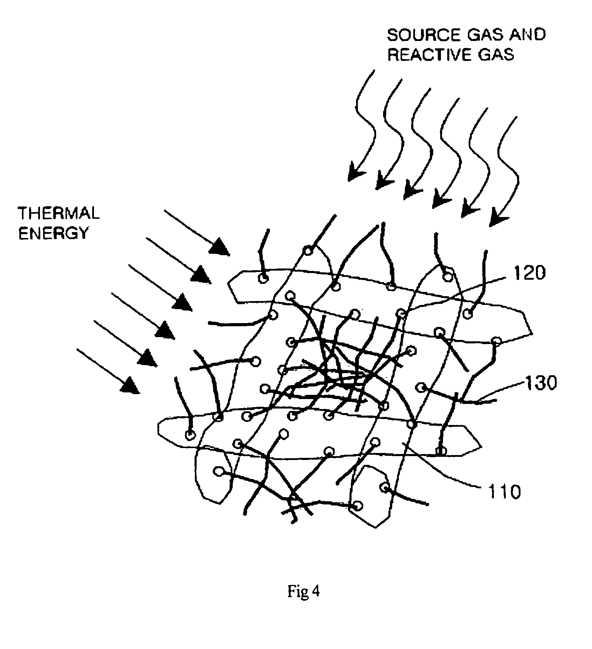

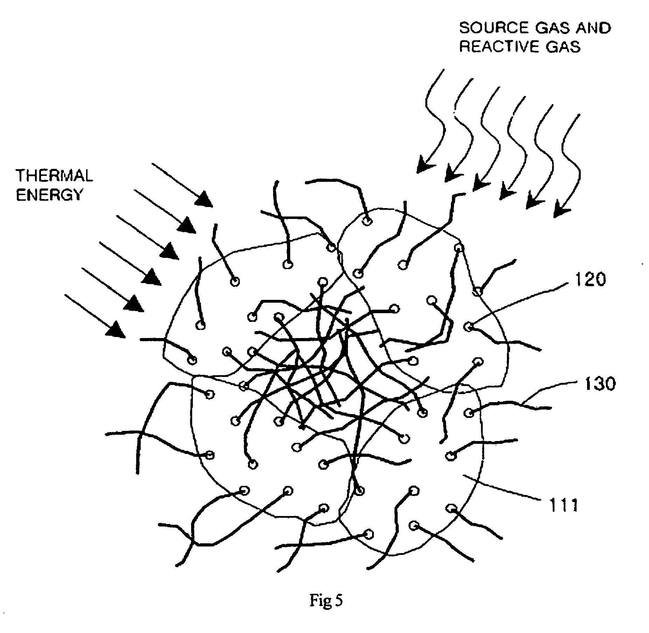

FIGS. 4 and 5 are views schematically illustrating the synthesis and growth of the nanotubes or nanofibers on the microfilter media, according to the present invention.

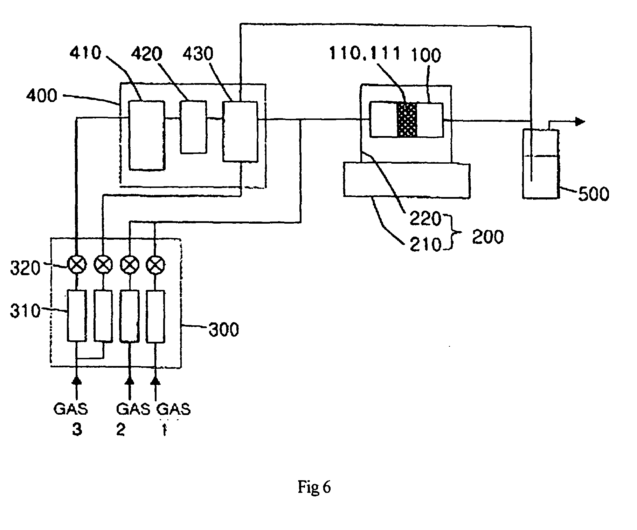

FIG. 6 is a view schematically illustrating the device for manufacturing the nanofilter media including the synthesized and grown nanotubes or nanofibers, according to the present invention.

As shown in FIG. 1, the method of manufacturing the nanofilter media is performed using the device for manufacturing the nanofilter media depicted in FIG. 6. The device for manufacturing the nanofilter media, which is shown in FIG. 6, is used to realize the preparation of the nanofilter media by synthesizing and growing the nanotubes or nanofibers from the catalyst nanoparticles attached to the microfilter media serving as a substrate.

Referring to FIGS. 2, 3 and 6, the device for manufacturing the nanofilter media according to the present invention includes a reactor 100 of FIG. 6 equipped with microfilter media serving as a substrate 110 of FIG. 2 or 111 of FIG. 3 having catalyst nanoparticles 120 of FIG. 2 or 3 attached to the substrate, in which the catalyst nanoparticles 120 formed of a transition metal are attached to the surface of the fibrous or fabric microfilter media 110 or the surface of the membrane microfilter media 111. The reactor 100 includes a conveyor line to transport the substrate.

In addition, the device of the present invention includes a heating unit 200 to simultaneously heat the catalyst nanoparticles 120 and the substrate 110 or 111 provided into the reactor 100, or selectively heat only the catalyst nanoparticles 120. The heating unit 200 may be equipped with a microwave generator 210 of FIG. 6 to generate microwaves and a microwave guide 220 of FIG. 6 to guide the generated microwaves into the reactor.

In addition, the above device includes a gas feeding unit 300 of FIG. 6 to feed the source gas and the reactive gas required to synthesize the nanotubes or nanofibers in the reactor 100, a catalyst nanoparticle forming and feeding unit 400 of FIG. 6 to form the catalyst nanoparticles 120 and feed the formed catalyst nanoparticles 120 into the reactor 100, and a discharging unit 500 of FIG. 6 to treat the gas discharged from the reactor 100.

The gas feeding unit 300 is provided with a gas bombe to feed the source gas such as a hydrocarbon gas or a silane gas, the reactive gas such as hydrogen sulfide gas, the cocatalyst gas such as thiophene, the reducing gas such as hydrogen gas, the oxidizing gas such as oxygen, and the carrier gas such as an inert gas. In addition, the gas feeding unit 300 further includes a mass flow controller (MFC) 310 of FIG. 6 mounted to a pipe line between the gas bombe and the reactor 100 and/or the catalyst nanoparticle forming and feeding unit 400 to control the amount of gas, and an on/off valve 320 of FIG. 6. The gas bombe, the MFC 310, and the on/off valve 320 may each be provided in a plurality of sets, if necessary.

As shown in FIGS. 2 and 3, the catalyst nanoparticles 120 are provided in the form of the transition metal, the precursor of the transition metal, or a mixture comprising transition metal and the cocatalyst component such as sulfur on the substrate 110 or 111. To this end, the catalyst nanoparticle forming and feeding unit 400, which is connected to the reactor 100, is provided.

As such, the catalyst nanoparticle forming and feeding unit 400 may be operated using any process able to feed the solid or liquid catalyst or catalyst precursor in the form of aerosol.

In addition, the catalyst nanoparticle forming and feeding unit 400 includes a catalyst nanoparticle forming part 410 of FIG. 6, and further includes a catalyst nanoparticle classification part 420 of FIG. 6 or a concentration controlling part 430 of FIG. 6 to control the concentration of the catalyst nanoparticles, if necessary.

According to the process of manufacturing the nanofilter media depicted in FIG. 1 using the device for manufacturing the nanofilter media, the catalyst nanoparticles 120 are first formed at step 1000 of FIG. 1.

The process of forming the catalyst nanoparticles includes all the known processes of synthesizing nanoparticles, modified processes of synthesizing the nanoparticles, or combinations thereof. For example, there are IGC, CVC, aerosol spraying, etc.

The formed catalyst nanoparticles 120 may be in solid or liquid phase.

The material for formed catalyst nanoparticles 120 includes a pure transition metal, a transition metal compound, a transition metal precursor, or a transition metal compound containing the sulfur.

As shown in FIG. 6, the catalyst nanoparticles 120 formed using the catalyst nanoparticle forming part 410 may be fed into the reactor 100 without change.

In addition, the catalyst nanoparticles 120 formed using the catalyst nanoparticle forming part 410 as in FIG. 6 are classified into catalyst nanoparticles 120 having a desired diameter using the nanoparticle classification part 420, and then fed into the reactor 100.

In addition, the catalyst nanoparticles 120 formed using the catalyst nanoparticle forming part 410 as in FIG. 6 may be further mixed with the source gas, the reactive gas or the mixture gas thereof, using the concentration controlling part 430 to control the concentration of the nanoparticles, and discharged while the concentration of the catalyst nanoparticles 120 is controlled, and then fed into the reactor 100, if required.

In this way, the catalyst nanoparticles 120 formed using the nanoparticle forming and feeding unit 400 of FIG. 6 are fed into the reactor 100 of FIG. 6, and subsequently, attached to the microfilter media, which have been previously provided in the reactor 100, at step 1100 of FIG. 1.

In addition, the microfilter media serving as a substrate 110 or 111 which the catalyst nanoparticles 120 have been previously attached to may be provided into the reactor 100.

In addition, the catalyst nanoparticles 120 formed using the catalyst nanoparticle forming part 410 are classified into catalyst nanoparticles 120 having a desired diameter using the nanoparticle classification part 420, and the classified catalyst nanoparticles are attached to the microfilter media serving as a substrate 110 or 111 in the reactor 100.

In addition, the catalyst nanoparticles 120 formed using the catalyst nanoparticle forming part 410, or the catalyst nanoparticles 120 classified using the nanoparticle classification part 420 may be fed into the reactor 100 while the concentration thereof is controlled by the source gas, the reactive gas or the mixture gas thereof additionally fed through the concentration controlling part 430 to control the concentration of the nanoparticles, and thus, may be attached to the microfilter media serving as a substrate 110 or 111.

After the nanoparticles 120 attached to the microfilter media serving as a substrate 110 or 111 while maintaining a predetermined distribution degree in the reactor 100 are prepared, the source gas or the reactive gas is fed into the reactor 100 at step 1200 of FIG. 1.

The source gas is selected depending on the material for nanotubes or nanofibers 130 which are synthesized and grown on the substrate 110 or 111. For example, to synthesize a carbon nanotubes or carbon nanofibers, a hydrocarbon gas, such as acetylene gas, methane gas, propane gas or benzene may be used as the source gas.

The reactive gas includes a cocatalyst gas, a reducing gas, an oxidizing gas, a carrier gas, or mixtures thereof.

As such, the cocatalyst gas is an adjuvant catalyst used to accelerate the synthesis and growth of the nanotubes or nanofibers 130 from the catalyst nanoparticles 120 as in FIG. 4, and is exemplified by hydrogen sulfide (H₂S) gas and thiophene vapor. The hydrogen sulfide gas and the thiophene vapor react with the catalyst nanoparticles 120 of the transition metal while predetermined thermal energy is supplied to the reactor 100, so that the above catalyst nanoparticles 120 are converted into catalyst nanoparticles of transition metal sulfide to decrease the melting point of the catalyst nanoparticles.

Thereby, since the temperature required to synthesize and grow the nanotubes or nanofibers 130 may be decreased using the catalyst nanoparticles 120 of the transition metal sulfide having a low melting point, deformation and breakage due to deterioration of the substrate may be prevented.

The reducing gas functions to reduce the catalyst nanoparticles 120 of the transition metal which have been previously oxidized while predetermined thermal energy is supplied to the reactor 100, and is exemplified by hydrogen gas.

The oxidizing gas may be used for oxidation of a product or a by-product in the reactor 100 during or after synthesis, if required.

The carrier gas is fed into the reactor 100 along with the above gases to be fed into the reactor 100, and thus, functions to control the concentration of the above gases or the flow rate of gas in the reactor 100, if required. Such a carrier gas includes, for example, an inert gas such as a helium gas or an argon gas, or a nitrogen gas.

Subsequently, the thermal energy is supplied to the substrate 110 or 111 in the reactor 100, the catalyst nanoparticles 120, or the source gas and the reactive gas to synthesize and grow the nanotubes or nanofibers 130 from the catalyst nanoparticles 120 attached to the substrate 110 or 111 as seen in FIGS. 3 and 4 at step 1300 of FIG. 1.

The substrate 110 or 111 in the reactor 100, the catalyst nanoparticles 120, or the source gas and the reactive gas may be simultaneously heated, or selectively heated, if necessary.

The heating unit 200 used to supply the thermal energy to the reactor 100 may be appropriately selected depending on the material of the substrate 100 or 111 in the reactor 100, that is, depending on whether or not the substrate 110 or 111 is required to be protected from heat.

Such a heating unit 200, which functions to supply the thermal energy to the reactor 100, may include, for example, a resistance coil heater, a microwave radiator, an electromagnetic induction heater, a laser heater, or an RF heater.

The heating unit 200 may selectively heat the catalyst nanoparticles 120, the substrate 110 or 111, or the source gas and the reactive gas, or may heat the entire reactor.

Finally, the nanotubes or nanofibers 130 are synthesized and grown while maintaining the predetermined porous properties of the microfilter media serving as a substrate 110 or 111 by controlling the process conditions for manufacturing the nanofilter media, including the conditions of the size and the number concentration of the catalyst nanoparticles 120, to obtain desired nanofilter media at step 1400 of FIG. 1.

In the nanofilter media, the diameter of the synthesized nanotubes or nanofibers 130 may be controlled by adjusting the size of the catalyst nanoparticles 120.

In the nanofilter media, the distribution degree, that is, the density of the nanotubes or nanofibers 130, may be controlled by adjusting the synthesis conditions, such as distribution concentration of the catalyst nanoparticles 120, concentration of the source gas, time periods or temperatures required for synthesis, etc.

As described hereinbefore, the present invention provides a method and device for manufacturing nanofilter media, in which the catalyst nanoparticles are attached to the microfilter media serving as a substrate, from which the nanotubes or nanofibers are synthesized in the presence of the source gas and/or the reactive gas while supplying predetermined energy required to induce the synthetic reaction using a predetermined heating unit. Thereby, the nanofilter media can be obtained by synthesizing and growing the nanotubes or nanofibers from the catalyst nanoparticles in a bottom-up manner.

In the nanofilter media, the diameter and solidity of the nanotubes or nanofibers which are synthesized and grown may be controlled by the size and the number concentration of the catalyst nanoparticles attached on the microfilter media as a substrate, and other synthesis conditions.

## Claims

1. A method of manufacturing nanofilter media, comprising:
feeding catalyst nanoparticles (120) into a reactor (100) to attach the catalyst nanoparticles (120) to microfilter media (110) serving as a substrate (110) provided in the reactor (100);
feeding a source gas and a reactive gas onto the catalyst nanoparticles (120); and
heating the reactor (100) using a heating unit (200) to synthesize and grow nanotubes or nanofibers from the catalyst nanoparticles (120) in the heated reactor (100), to obtain nanofilter media composed of the nanotubes or nanofibers synthesized and grown on the microfilter media (110),
**characterized in that** the feeding of the catalyst nanoparticles is performed by classifying the catalyst nanoparticles (120) into catalyst nanoparticles having a predetermined diameter using a nanoparticle classification part (420), and then feeding the classified catalyst nanoparticles (120) into the reactor (100),
wherein the reactor (100) comprises a conveyor line through which the microfilter media (110) are continuously transported.

2. The method as set forth in claim 1, wherein the microfilter media (110) comprise a fibrous filter, a fabric filter, or a membrane filter.

3. The method as set forth in claim 1, wherein a material for the microfilter media (110) comprises a polymer, silicon oxide, alumina, ceramics, or metal oxides.

4. The method as set forth in claim 1, wherein the catalyst nanoparticles (120) are prepared using inert gas condensation processes including resistance heating, plasma heating, induction heating or laser heating, chemical vapor condensation processes using a resistance coil reactor, a flame reactor, a laser reactor or a plasma reactor, or liquid processes including direct precipitation, coprecipitation, freeze drying, and spray pyrolysis.

5. The method as set forth in claim 1, wherein the catalyst nanoparticles (120) comprise a transition metal, sulfides, carbides, oxides or salts of the transition metal, or an organic compound containing the transition metal.

6. The method as set forth in claim 1, wherein the catalyst nanoparticles (120) are in a solid phase or a liquid phase.

7. The method as set forth in claim 1, wherein the attachment of the catalyst nanoparticles (120) is performed by feeding, dispersing and attaching the catalyst nanoparticles onto the microfilter media serving as a substrate provided in the reactor (100) to be attached to the substrate.

8. The method as set forth in claim 1, wherein the attachment of the catalyst nanoparticles (120) is performed by supporting the catalyst nanoparticles on the microfilter media serving as a substrate (110) using painting, dipping, spraying or deposition, and then the microfilter media which the catalyst nanoparticles are attached on are provided into the reactor (100).

9. The method as set forth in claim 1, wherein the feeding of the catalyst nanoparticles (120) is performed by controlling the catalyst nanoparticles (120) to have a predetermined number concentration using a concentration controlling part (430) to control the concentration of the nanoparticles (120), and then feeding the controlled catalyst nanoparticles (120) into the reactor (100).

10. The method as set forth in claim 1, wherein the catalyst nanoparticles (120) comprise separate catalyst nanoparticles.

11. The method as set forth in claim 1, wherein the catalyst nanoparticles (120) comprise an aggregate in which the catalyst nanoparticles (120) adhere to each other.

12. The method as set forth in claim 1, wherein the source gas comprises a carbon source gas including a hydrocarbon gas.

13. The method as set forth in claim 1, wherein the source gas comprises a silicon source gas including a silane gas.

14. The method as set forth in claim 1, wherein the reactive gas comprises a cocatalyst gas, a reducing gas, an oxidizing gas, an inert gas, or mixtures thereof.

15. The method as set forth in claim 1, wherein the heating unit (200) comprises a resistance coil heater, a microwave radiator, an electromagnetic induction heater, a laser heater, or a radio frequency heater.

16. The method as set forth in claim 1, wherein the heating unit (200) is used to selectively heat the catalyst nanoparticles (120), the substrate (110), or the source gas and reactive gas, or to heat the entire reactor (100).

17. The method as set forth in claim 1, wherein the nanotube comprises carbon nanotubes.

18. The method as set forth in claim 1, wherein the nanofiber comprises carbon nanofibers.

19. The method as set forth in claim 1, wherein the nanofiber comprises silicon (Si) fibers.

20. The method as set forth in claim 1, wherein the nanofiber comprises silicon dioxide (SiO₂) fibers.

21. The method as set forth in claim 1, wherein the nanofilter media comprise filter media including the carbon nanotubes synthesized and grown on the microfilter media (110) in a bottom-up manner.

22. The method as set forth in claim 1, wherein the nanofilter media comprise filter media which function to simultaneously perform dust collection and gas adsorption.

23. The method as set forth in claim 1, wherein the nanofilter media comprise catalyst filter media, antibiotic filter media, or deodorization filter media, functioning to remove volatile organic compounds, sterilize air, or perform deodorization, by additionally depositing metal nanoparticles onto the nanotubes or nanofibers.

24. The method as set forth in claim 1, wherein the nanofilter media comprise high strength filter media having high mechanical strength.

25. The method as set forth in claim 1, wherein the nanofilter media comprise heat resistant filter media able to endure high temperatures.

26. The method as set forth in claim 1, wherein the nanofilter media comprise chemical proof filter media which are resistant to predetermined chemicals.

27. The method as set forth in claim 5, wherein the catalyst nanoparticles formed of the transition metal comprise the transition metal converted from a transition metal precursor, which is supported on the microfilter media serving as a substrate, through reduction, sintering, sulfurization or carbonization.

28. The method as set forth in claim 5, wherein the catalyst nanoparticles formed of the metal sulfide comprise metal sulfide formed by sulfurizing the catalyst nanoparticles of the transition metal with hydrogen sulfide (H₂S) or thiophene.

29. The method as set forth in claim 5, wherein the catalyst nanoparticles formed of the metal sulfide comprise nanoparticles composed of a solid particulate mixture including the transition metal and sulfur.

30. The method as set forth in claim 5, wherein the catalyst nanoparticles formed of the metal sulfide comprise droplet nanoparticles composed of an ionic solution including the transition metal and sulfur.

31. The method as set forth in claim 5, wherein the catalyst nanoparticles formed of the organic compound comprise droplet nanoparticles composed of a nanodroplet catalyst precursor.

32. The method as set forth in claim 14, wherein the cocatalyst gas comprises a hydrogen sulfide (H₂S) gas or thiophene vapor.

33. The method as set forth in claim 14, wherein the inert gas comprises helium gas or argon gas to transport the catalyst nanoparticles or dilute the reactive gas.

34. The method as set forth in claim 31, wherein the catalyst precursor comprises ferrocene, iron-pentacarbonyl, dicobalt-octacarbonyl, or nickel-carbonyl.

35. A device for manufacturing nanofilter media, comprising:
a reactor (100) equipped with microfilter media (110) serving as a substrate on which nanotubes or nanofibers are synthesized and grown;
a catalyst nanoparticle forming and feeding unit (400) to form catalyst nanoparticles (120) and feed the formed catalyst nanoparticles (120) into the reactor (100) so as to synthesize and grow the nanotubes or nanofibers:
a gas feeding unit (300) to feed a source gas and a reactive gas into the reactor (100) to synthesize and grow the nanotubes or nanofibers; and
a heating unit (200) to heat the reactor (100),
**characterized in that** it further comprises a nanoparticle classification part to classify the nanoparticles into catalyst nanoparticles having a predetermined diameter before feeding the classified catalyst into the reactor
wherein the reactor (100) comprises a conveyor line through which the microfilter media (110) are continuously transported.

## Patentansprüche

1. Verfahren zur Herstellung von Nanofiltermedien, umfassend:
Zuführen von Katalysator-Nanoteilchen (120) in einen Reaktor (100), um die Katalysator-Nanoteilchen (120) an Mikrofiltermedien (110), die als ein im Reaktor (100) bereitgestelltes Substrat (110) dienen, anzulagern;
Zuführen eines Quellgases und eine Reaktionsgases auf die Katalysator-Nanoteilchen (120); und
Erwärmen des Reaktors (100) unter Verwendung einer Heizeinheit (200), um Nanoröhrchen oder Nanofasern aus den Katalysator-Nanoteilchen (120) in dem erwärmten Reaktor (100) aufzubauen und wachsen zu lassen, um Nanofiltermedien, bestehend aus den auf den Mikrofiltermedien (110) aufgebauten und gewachsenen Nanoröhrchen oder Nanofasern, zu erhalten,
**dadurch gekennzeichnet, dass** das Zuführen der Katalysator-Nanoteilchen durch Klassifizieren der Katalysator-Nanoteilchen (120) in Katalysator-Nanoteilchen mit einem vorbestimmten Durchmesser unter Verwendung eines Nanoteilchen-Klassifizierungsteils (420) und dann Zuführen der klassifizierten Katalysator-Nanoteilchen (120) in den Reaktor (100) durchgeführt wird,
wobei der Reaktor (100) ein Förderband umfasst, auf welchem die Mikrofiltermedien (110) fortlaufend transportiert werden.

2. Verfahren nach Anspruch 1, wobei die Mikrofiltermedien (110) ein Gewebefilter, ein Tuchfilter oder ein Membranfilter umfassen.

3. Verfahren nach Anspruch 1, wobei ein Material für die Mikrofiltermedien (110) ein Polymer, Siliziumoxid, Aluminiumoxid, keramische Stoffe oder Metalloxide umfasst.

4. Verfahren nach Anspruch 1, wobei die Katalysator-Nanoteilchen (120) unter Verwendung von Inertgas-Kondensationsprozessen einschließlich Widerstandserwärmung, Plasmaerwärmung, Induktionserwärmung oder Lasererwärmung, von chemischen Gasphasen-Kondensationsprozessen, die einen Widerstandsspulenreaktor, einen Flammenreaktor, einen Laserreaktor oder einen Plasmareaktor nutzen, oder von Flüssigprozessen einschließlich Direktabscheidung, Copräzipitation, Gefriertrocknen und Spray-Pyrolyse, hergestellt werden.

5. Verfahren nach Anspruch 1, wobei die Katalysator-Nanoteilchen (120) ein Übergangsmetall, Sulfite, Karbide, Oxide oder Salze des Übergangsmetalls, oder eine organische Zusammensetzung, die das Übergangsmetall enthält, umfassen.

6. Verfahren nach Anspruch 1, wobei die Katalysator-Nanoteilchen (120) in einer festen Phase oder einer flüssigen Phase sind.

7. Verfahren nach Anspruch 1, wobei die Anlagerung der Katalysator-Nanoteilchen (120) durch Zuführen, Dispergieren und Anlagern der Katalysator-Nanoteilchen auf den Mikrofiltermedien durchgeführt wird, die als ein im Reaktor (100) bereitgestelltes Substrat dienen, um am Substrat angelagert zu werden.

8. Verfahren nach Anspruch 1, wobei die Anlagerung der Katalysator-Nanoteilchen (120) durch Lagern der Katalysator-Nanoteilchen auf den Mikrofiltermedien, die als ein Substrat (110) dienen, unter Verwendung von Bemalen, Eintauchen, Besprühen oder Abscheidung, durchgeführt wird, und die Mikrofiltermedien, auf denen die Katalysator-Nanoteilchen angelagert sind, dann in dem Reaktor (100) bereitgestellt werden.

9. Verfahren nach Anspruch 1, wobei das Zuführen der Katalysator-Nanoteilchen (120) durch Beeinflussen der Katalysator-Nanoteilchen (120), damit diese eine vorbestimmte Konzentration aufweisen, unter Verwendung eines Konzentrationsbeeinflussungsteils (430), um die Konzentration der Nanoteilchen (120) zu beeinflussen, und dann Zuführen der beeinflussten Katalysator-Nanoteilchen (120) in den Reaktor (100) durchgeführt wird.

10. Verfahren nach Anspruch 1, wobei die Katalysator-Nanoteilchen (120) getrennte Katalysator-Nanoteilchen umfassen.

11. Verfahren nach Anspruch 1, wobei die Katalysator-Nanoteilchen (120) ein Aggregat umfassen, in dem die Katalysator-Nanoteilchen (120) aneinander anhaften.

12. Verfahren nach Anspruch 1, wobei das Quellgas ein Kohlenstoffquellgas, einschließlich eines Kohlenwasserstoffgases, umfasst.

13. Verfahren nach Anspruch 1, wobei das Quellgas ein Siliziumquellgas, einschließlich eines Siliziumwasserstoffgases, umfasst.

14. Verfahren nach Anspruch 1, wobei das Reaktionsgas ein Co-Katalysatorgas, ein Reduktionsgas, ein Oxidationsgas, ein Inertgas oder Mischungen daraus umfasst.

15. Verfahren nach Anspruch 1, wobei die Heizeinheit (200) eine Widerstandsspulen-Heizvorrichtung, eine Mikrowellen-Heizvorrichtung, eine Heizvorrichtung mit elektromagnetischer Induktion, eine Laser-Heizvorrichtung oder eine Hochfrequenz-Heizvorrichtung umfasst.

16. Verfahren nach Anspruch 1, wobei die Heizeinheit (200) verwendet wird, um wahlweise die Katalysator-Nanoteilchen (120), das Substrat (110) oder das Quellgas und das Reaktionsgas zu erwärmen, oder um den gesamten Reaktor (100) zu erwärmen.

17. Verfahren nach Anspruch 1, wobei die Nanoröhrchen Kohlenstoff-Nanoröhrchen umfassen.

18. Verfahren nach Anspruch 1, wobei die Nanofasern Kohlenstoff-Nanofasern umfassen.

19. Verfahren nach Anspruch 1, wobei die Nanofasern Siliziumfasern (Si) umfassen.

20. Verfahren nach Anspruch 1, wobei die Nanofasern Siliziumdioxidfasern (SiO₂) umfassen.

21. Verfahren nach Anspruch 1, wobei die Nanofiltermedien Filtermedien einschließlich der Kohlenstoff-Nanoröhrchen, die auf den Mikrofiltermedien (110) von unten nach oben aufgebaut und gewachsen sind, umfassen.

22. Verfahren nach Anspruch 1, wobei die Nanofiltermedien Filtermedien umfassen, die gleichzeitig dazu dienen, Staub zu sammeln und Gas zu adsorbieren.

23. Verfahren nach Anspruch 1, wobei die Nanofiltermedien Katalysatorfiltermedien, antibiotische Filtermedien, oder geruchsbeseitigende Filtermedien umfassen, die dazu dienen, flüchtige organische Verbindungen zu entfernen, die Luft zu sterilisieren oder Gerüche zu beseitigen, indem zusätzlich Metall-Nanoteilchen auf den Nanoröhrchen oder Nanofasern abgelagert werden.

24. Verfahren nach Anspruch 1, wobei die Nanofiltermedien hochfeste Filtermedien mit hoher mechanischer Festigkeit umfassen.

25. Verfahren nach Anspruch 1, wobei die Nanofiltermedien wärmebeständige Filtermedien umfassen, die hohe Temperaturen aushalten können.

26. Verfahren nach Anspruch 1, wobei die Nanofiltermedien chemiefeste Filtermedien umfassen, die gegenüber vorbestimmten Chemikalien beständig sind.

27. Verfahren nach Anspruch 5, wobei die Katalysator-Nanoteilchen, die aus dem Übergangsmetall gebildet sind, das Übergangsmetall, das aus einem Übergangsmetall-Vorprodukt umgewandelt wurde, umfassen, das auf den Mikrofiltermedien, die als ein Substrat dienen, durch Reduktion, Sintern, Schwefelung oder Karbonisierung gelagert ist.

28. Verfahren nach Anspruch 5, wobei die Katalysator-Nanoteilchen, die aus dem Metallsulfid gebildet sind, Metallsulfid umfassen, das durch Schwefelung der Katalysator-Nanoteilchen des Übergangsmetalls mit Wasserstoffsulfid (H₂S) oder Thiophen gebildet wird.

29. Verfahren nach Anspruch 5, wobei die Katalysator-Nanoteilchen, die aus dem Metallsulfid gebildet sind, Nanoteilchen umfassen, die aus einer Festpartikelmischung, umfassend das Übergangsmetall und Schwefel, zusammengesetzt sind.

30. Verfahren nach Anspruch 5, wobei die Katalysator-Nanoteilchen, die aus dem Metallsulfid gebildet sind, Tröpfchen-Nanoteilchen umfassen, die aus einer ionischen Lösung, umfassend das Übergangsmetall und Schwefel, zusammengesetzt sind.

31. Verfahren nach Anspruch 5, wobei die Katalysator-Nanoteilchen, die aus der organischen Zusammensetzung gebildet sind, Tröpfchen-Nanoteilchen umfassen, die aus einem Nanotröpfchen-Katalysator-Vorprodukt bestehen.

32. Verfahren nach Anspruch 14, wobei das Cokatalysatorgas ein Wasserstoffsulfidgas (H₂S) oder Thiophendampf umfasst.

33. Verfahren nach Anspruch 14, wobei das Inertgas Heliumgas oder Argongas umfasst, um die Katalysator-Nanoteilchen zu transportieren oder das Reaktionsgas zu verdünnen.

34. Verfahren nach Anspruch 31, wobei das Katalysator-Vorprodukt Ferrocen, Eisenpentacarbonyl, Dikobalt-Oktacarbonyl oder Nickelcarbonyl umfasst.

35. Vorrichtung zur Herstellung von Nanofiltermedien, umfassend:
einen Reaktor (100), der mit Mikrofiltermedien (110) ausgestattet ist, die als ein Substrat dienen, auf dem Nanoröhrchen oder Nanofasern aufgebaut werden und wachsen;
eine Katalysator-Nanoteilchen-Ausbildungs- und Zuführeinheit (400), um Katalysator-Nanoteilchen (120) auszubilden und die ausgebildeten Katalysator-Nanoteilchen (120) in den Reaktor (100) zuzuführen, um so die Nanoröhrchen oder Nanofasern aufzubauen und wachsen zu lassen;
eine Gaszuführeinheit (300) zum Zuführen eines Quellgases und eines Reaktionsgases in den Reaktor (100), um die Nanoröhrchen oder Nanofasern aufzubauen und wachsen zu lassen; und
eine Heizeinheit (200), um den Reaktor (100) zu erwärmen,
**dadurch gekennzeichnet, dass** sie ferner ein Nanoteilchen-Klassifizierungsteil umfasst, um die Nanoteilchen in Katalysator-Nanoteilchen mit einem vorbestimmten Durchmesser zu klassifizieren, bevor die klassifizierten Katalysator-Nanoteilchen in den Reaktor zugeführt werden,
wobei der Reaktor (100) ein Förderband umfasst, auf welchem die Mikrofiltermedien (110) fortlaufend transportiert werden.

## Revendications

1. Procédé de fabrication d'un milieu de nanofiltration, comprenant :
l'alimentation de nanoparticules de catalyseur (120) dans un réacteur (100) pour fixer les nanoparticules de catalyseur (120) au milieu de microfiltration (110) servant de substrat (110) fourni dans le réacteur (100) ;
l'alimentation d'un gaz de source et d'un gaz réactif sur les nanoparticules de catalyseur (120) ; et
le chauffage du réacteur (100), en utilisant une unité de chauffage (200) pour synthétiser et développer des nanotubes ou nanofibres provenant des nanoparticules de catalyseur (120) dans le réacteur chauffé (100), afin d'obtenir un milieu de nanofiltration composé de nanotubes ou nanofibres synthétisées et développées sur le milieu de microfiltration (110),
**caractérisé en ce que** l'alimentation des nanoparticules de catalyseur est effectuée en classant les nanoparticules de catalyseur (120) en nanoparticules de catalyseur ayant un diamètre prédéterminé en utilisant une partie de classification de nanoparticules (420), puis en alimentant les nanoparticules de catalyseur classées (120) dans le réacteur (100),
dans lequel le réacteur (100) comprend une ligne de convoyeur à travers laquelle le milieu de microfiltration (110) est continuellement transporté.

2. Procédé selon la revendication 1, dans lequel le milieu de microfiltration (110) comprend un filtre fibreux, un filtre en tissu, ou un filtre à membrane.

3. Procédé selon la revendication 1, dans lequel un matériau pour le milieu de microfiltration (110) comprend un polymère, un oxyde de silicium, de l'alumine, de la céramique, ou des oxydes métalliques.

4. Procédé selon la revendication 1, dans lequel les nanoparticules de catalyseur (120) sont préparées en utilisant des processus de condensation de gaz inerte comprenant un chauffage par résistance, un chauffage au plasma, un chauffage par induction ou un chauffage au laser, des processus de condensation de vapeur chimiques utilisant un réacteur à bobine de résistance, un réacteur à flamme, un réacteur laser ou un réacteur au plasma ou des processus liquides comprenant la précipitation directe, la co-précipitation, la lyophilisation et la pyrolyse par vaporisation.

5. Procédé selon la revendication 1, dans lequel les nanoparticules de catalyseur (120) comprennent un métal de transition, des sulfures, des carbures, des oxydes ou sels du métal de transition, ou un composé organique contenant le métal de transition.

6. Procédé selon la revendication 1, dans lequel les nanoparticules de catalyseur (120) sont dans une phase solide ou dans une phase liquide.

7. Procédé selon la revendication 1, dans lequel la fixation des nanoparticules de catalyseur (120) est effectuée en alimentant, dispersant et fixant les nanoparticules de catalyseur sur le milieu de microfiltration servant de substrat fourni dans le réacteur (100) à fixer au substrat.

8. Procédé selon la revendication 1, dans lequel la fixation des nanoparticules de catalyseur (120) est effectuée en supportant les nanoparticules de catalyseur sur le milieu de microfiltration servant de substrat (110) en utilisant la peinture, l'immersion, la vaporisation ou la déposition, et ensuite le milieu de microfiltration, auquel les nanoparticules de catalyseur sont fixées, est fourni dans le réacteur (100).

9. Procédé selon la revendication 1, dans lequel l'alimentation des nanoparticules de catalyseur (120) est réalisée en contrôlant les nanoparticules de catalyseur (120) pour avoir une concentration en nombre prédéterminée, en utilisant une partie de contrôle de la concentration (430), afin de contrôler la concentration des nanoparticules (120), puis en alimentant les nanoparticules de catalyseur contrôlées (120) dans le réacteur (100).

10. Procédé selon la revendication 1, dans lequel les nanoparticules de catalyseur (120) comprennent des nanoparticules de catalyseur séparées.

11. Procédé selon la revendication 1, dans lequel les nanoparticules de catalyseur (120) comprennent un agrégat dans lequel les nanoparticules de catalyseur (120) adhèrent les unes aux autres.

12. Procédé selon la revendication 1, dans lequel le gaz de source comprend un gaz de source de carbone comprenant un gaz hydrocarbure.

13. Procédé selon la revendication 1, dans lequel le gaz de source comprend un gaz de source de silicium comprenant un gaz silane.

14. Procédé selon la revendication 1, dans lequel le gaz réactif comprend un gaz co-catalyseur, un gaz réducteur, un gaz oxydant, un gaz inerte ou des mélanges correspondants.

15. Procédé selon la revendication 1, dans lequel l'unité de chauffage (200) comprend un chauffage à bobine à résistance, un radiateur à micro-ondes, un chauffage à induction électromagnétique, un chauffage au laser, ou un chauffage à fréquence radio.

16. Procédé selon la revendication 1, dans lequel l'unité de chauffage (200) est utilisée pour chauffer sélectivement les nanoparticules de catalyseur (120), le substrat (110) ou le gaz de source et le gaz réactif, ou pour chauffer le réacteur entier (100).

17. Procédé selon la revendication 1, dans lequel le nanotube comprend des nanotubes de carbone.

18. Procédé selon la revendication 1, dans lequel la nanofibre comprend des nanofibres de carbone.

19. Procédé selon la revendication 1, dans lequel la nanofibre comprend des fibres de silicium (Si).

20. Procédé selon la revendication 1, dans lequel la nanofibre comprend des fibres de dioxyde de silicium (SiO₂).

21. Procédé selon la revendication 1, dans lequel le milieu de nanofiltration comprend un milieu de filtration comprenant les nanotubes de carbone synthétisés et développés sur le milieu de microfiltration (110) de bas en haut.

22. Procédé selon la revendication 1, dans lequel le milieu de nanofiltration comprend un milieu de filtration qui fonctionne pour réaliser simultanément la collecte de poussière et l'adsorption de gaz.

23. Procédé selon la revendication 1, dans lequel le milieu de nanofiltration comprend un milieu de filtration catalyseur, un milieu de filtration antibiotique, ou un milieu de filtration de désodorisation, fonctionnant de façon à enlever les composés organiques, à stériliser l'air, ou à effectuer une désodorisation, en déposant en outre des nanoparticules métalliques sur les nanotubes ou nanofibres.

24. Procédé selon la revendication 1, dans lequel le milieu de nanofiltration comprend un milieu de filtration à résistance élevée ayant une résistance mécanique élevée.

25. Procédé selon la revendication 1, dans lequel le milieu de nanofiltration comprend un milieu filtrant résistant à la chaleur capable de supporter des températures élevées.

26. Procédé selon la revendication 1, dans lequel le milieu de nanofiltration comprend un milieu filtrant étanche aux produits chimiques qui est résistant à des produits chimiques prédéterminés.

27. Procédé selon la revendication 5, dans lequel les nanoparticules de catalyseur formées du métal de transition comprennent le métal de transition converti d'un précurseur de métal de transition, qui est supporté sur le milieu de microfiltration servant de substrat, par une réduction, un frittage, une sulfurisation ou une carbonisation.

28. Procédé selon la revendication 5, dans lequel les nanoparticules de catalyseur formées du sulfure de métal comprennent du sulfure de métal formé en sulfurisant les nanoparticules de catalyseur du métal de transition avec du sulfure d'hydrogène (H₂S) ou thiophène.

29. Procédé selon la revendication 5, dans lequel les nanoparticules de catalyseur formés du sulfure de métal comprennent des nanoparticules composées d'un mélange particulaire solide comprenant le métal de transition et le soufre.

30. Procédé selon la revendication 5, dans lequel les nanoparticules de catalyseur formées de sulfure métallique comprennent des nanoparticules en gouttelettes composées d'une solution ionique comprenant le métal de transition et le soufre.

31. Procédé selon la revendication 5, dans lequel les nanoparticules de catalyseur formées du composé organique comprennent des nanoparticules en gouttelettes composées d'un précurseur de catalyseur en nano-gouttelettes.

32. Procédé selon la revendication 14, dans lequel le gaz co-catalyseur comprend un gaz sulfure d'hydrogène (H₂S) ou une vapeur de thiophène.

33. Procédé selon la revendication 14, dans lequel le gaz inerte comprend du gaz hélium ou du gaz argon pour transporter les nanoparticules de catalyseur ou diluer le gaz réactif.

34. Procédé selon la revendication 31, dans lequel le précurseur de catalyseur comprend un ferrocène, un pentacarbonyle-fer, un octacarbonyle de dicobalt, ou un nickel-carbonyle.

35. Dispositif de fabrication d'un milieu de nanofiltration, comprenant :
un réacteur (100) équipé d'un milieu de microfiltration (110) servant de substrat sur lequel des nanotubes ou nanofibres sont synthétisés et développés ;
une unité de formation et d'alimentation de nanoparticules de catalyseur (400) pour former des nanoparticules de catalyseur (120) et alimenter les nanoparticules de catalyseur formées (120) dans le réacteur (100), de façon à synthétiser et développer les nanotubes ou nanofibres ;
une unité d'alimentation de gaz (300) pour alimenter un gaz de source et un gaz réactif dans le réacteur (100) afin de synthétiser et de développer les nanotubes ou nanofibres ; et
une unité de chauffage (200) pour chauffer le réacteur (100),
**caractérisé en ce qu'**il comprend en outre une partie de classification de nanoparticules pour classer les nanoparticules en nanoparticules de catalyseur ayant un diamètre prédéterminé avant d'alimenter le catalyseur classé dans le réacteur,
dans lequel le réacteur (100) comprend une ligne de convoyeur à travers laquelle le milieu de microfiltration (110) est continuellement transporté.
